# EUROPÄISCHE PATENTSCHRIFT

(11) **EP 1 143 583 B1**
(45) Veröffentlichungstag und Bekanntmachung des Hinweises auf die Patenterteilung: **19.10.2005**
(21) Anmeldenummer: 01107790.6
(22) Anmeldetag: 04.04.2001
(51) Int. Cl.: H01S 5/40, H01S 5/02

(54) **Verfahren zur Kontaktierung eines Hochleistungsdiodenlaserbarrens und eine Hochleistungsdiodenlaserbarren-Kontakt-Anordnung**
High power diode laser bar contact system and contacting method for high power diode laser bars
Système de contact d'une barre de diodes laser haute puissance et méthode pour contacter cette barre de diodes laser haute puissance

(30) Priorität: 07.04.2000 DE 10018043
(43) Veröffentlichungstag der Anmeldung: 10.10.2001
(73) Patentinhaber: JENOPTIK Aktiengesellschaft, 07743 Jena (DE)
(72) Erfinder: Schröder, Matthias, 07646 Stadtroda (DE); Hänsel, Hartmut G., 07751 Drackendorf (DE); Lorenzen, Dirk, 07743 Jena (DE)
(74) Vertreter: Oehmke, Volker

(56) Entgegenhaltungen:
- EP-A- 0 905 833
- US-A- 5 212 707
- US-A- 5 284 790

## Beschreibung

**Die Erfindung betrifft ein Verfahren zur Kontaktierung eines Hochleistungsdiodenlaserbarrens und eine Hochleistungsdiodenlaserbarren-Kontakt-Anordnung von elektrischen Kontakten thermisch untergeordneter Funktion.**

**Hochleistungsdiodenlaserbarren (HDB)** sind Halbleiterlaser-Bauelemente von wenigstens zwei optisch im wesentlichen voneinander unabhängig betriebsfähigen Halbleiterlaser-Emittern von großer optischer Ausgangsleistung. Ihre mittleren optischen Linienleistungsdichten überschreiten 1 Watt/mm Bauelementbreite, ihre optischen Ausgangsleistungen überschreiten 10 Watt cw pro Bauelement. Die Reflexionsflächen der Halbleiterlaserresonatoren heißen Facetten und können ver- oder entspiegelt sein. Typischerweise bestehen HDB aus einem wenige 10 oder 100 µm starken dotierten Halbleitersubstrat, auf das ein pn-Übergang epitaktisch aufgewachsen wurde. HDB besitzen zwei Elektroden -eine Anode und eine Kathode- die substratseitig und epitaxieseitig bezüglich des HDB liegen. Eine epitaxieseitig emitterweise elektrisch getrennte Ausführung einer Elektrode ermöglicht den individuellen Betrieb einzelner Emitter. Die Elektroden eines HDB können eine Metallisierung tragen oder aber auch unmetallisiert sein.

HDB müssen für ihren Betrieb kontaktiert werden. Ein Kontakt, mit dem ein HBD verbunden wird, kann verschiedene Funktionen übernehmen. Zu diesen Funktionen können zählen: Die Stromzuführung zum HDB, die Wärmeabfuhr vom HDB und die mechanische Fixierung des HDB. Der Kontakt kann seine Funktion für HDB besonders gut erfüllen, wenn die Verbindung zwischen Kontakt und HDB stoffschlüssig ist.

Im folgenden wird unter einem elektrischen Kontakt für den HDB auch ein Ensemble von mehreren räumlich voneinander beabstandeten Kontaktkörpern gleicher elektrischer Polarität verstanden. In diesem Sinne bildet zum Beispiel eine Reihe von elektrischen Bonddrähten an der Kathode des HDB einen einzigen elektrischen (n-)Kontakt. Ebenso bildet zum Beipiel eine Reihe von Leiterbahnen auf einer Keramik, die zur epitaxieseitigen Kontaktierung des HDB an seinen Anoden, die für einen individuellen Betrieb der Emitter vorgesehen sind, einen einzigen elektrischen (p-)Kontakt. Ein elektrischer Kontakt für einen HDB kann also aus einer Vielzahl von mechanischen Kontakten bestehen.

Unter einem **Hochleistungsdiodenlaser (HDL)** wird ein mit einem elektrisch positiven (p-)Kontakt an der Anode des HDB und einem elektrisch negativen (n-) Kontakt an der Kathode des HDB stöffschlüssig verbundener HDB verstanden. Der HDB eines HDL besitzt definitionsgemäß genau zwei elektrische Kontakte einen positiven und einen negativen -, die epitaxie- und substratseitig an dem HDB befestigt sind.

Bei Betrieb des HDL erzeugt der HDB neben optischer Leistung auch einen beträchtlichen Teil thermische (Verlust-)leistung, insbesondere im Bereich des pn- Übergangs seiner Emitter nahe der Epitaxieseite des HDB. Die elektrischen Kontakte des HDB übernehmen zusätzlich thermische Funktion, in dem über sie thermische Leistung des HDB abgeführt wird. Besitzen beide elektrische Kontakte des HDL den selben thermischen Widerstand, so wird über den epitaxiseitigen Kontakt mehr thermische Leistung (Wärme) abgeführt als über den substratseitigen.

Als ein elektrischer Kontakt mit thermisch relevanter Funktion wird ein elektrischer Kontakt für den HDB definiert, über den mehr als ein Drittel der im HDB im Dauerstrich-(cw-)Betrieb erzeugten thermischen Leistung abgeführt werden.

Als ein elektrischer Kontakt mit thermisch untergeordneter Funktion wird ein elektrischer Kontakt für den HDB definiert, über den höchstens ein Drittel der im HDB im cw-Betrieb erzeugten thermischen Leistung abgeführt wird.

Nach dieser Definition benötigt ein HDB, der im cw-Regime betrieben wird, wenigstens einen elektrischen Kontakt mit thermisch relevanter Funktion. Im Pulsregime betrieben können definitionsgemäß beide elektrische Kontakte von untergeordneter thermischer Funktion sein, sofern die zeitlich gemittelte thermische Leistung zwei Drittel des Wertes der thermischen Spitzenleistung im Puls nicht überschreiten.

Ein Beipiel für einen elektrischen Kontakt mit thermisch relevanter Funktion ist ein metallisierter Diamantkörper, auf den der HDB epitaxieseitig großflächig gelötet wird und über den im Betrieb 90 % der im HDB produzierten Wärme abgeführt werden. Ein Beispiel für einen elektrischen Kontakt von thermisch untergeordneter Funktion ist eine Reihe von Bonddrähten, die an die substratseitig metallisierte Elektrode des HDB gebondet wurde und über die im cw-Betrieb 1 % der im HDB produzierten Wärme abgeführt wird.

Ein anderes Beispiel für einen elektrischen Kontakt mit thermisch untergeordneter Funktion ist ein Kupfer-Wolfram-Substrat, auf das der HDB epitaxieseitig gelötet wurde und über das im Pulsbetrieb mit einem Tastverhältnis von 35 % im zeitlichen Mittel 31,5 % der im HDB produzierten Pulsspitzenwärmeleistung oder 90 % der im HDB im zeitlichen Mittel produzierten Wärmeleistung abgeführt werden.

Die stoffschlüssige Verbindung von einem HDB und einem elektrischen Kontakt beinhaltet eine mehr oder weniger stark ausgeprägte Fügezone zwischen den beiden Verbindungspartnern. Die stoffschlüssige Verbindung zwischen einem HDB und einem elektrischen Kontakt erfolgt in einem stoffschlüssigen Verbindungsprozeß, einem Fügeprozeß, nach einem Fügeverfahren. Der Fügeprozeß kann unter der Beteiligung eines zusätzlichen Fügewerkstoffes erfolgten.

Der Fügeprozeß beginnt mit dem Inkontaktbringen der Fügepartner miteinander oder mit einem zusätzlichen Fügewerkstoff. Er endet mit dem Erreichen einer stoffschlüssigen Verbindung, deren Eigenschaften die beabsichtigte Funktion ihre Herstellung erfüllt. Zu diesen Eigenschaften können zählen: ausreichende elektrische Leitfähigkeit, ausreichende thermische Leitfähigkeit, ausreichende mechanische Festigkeit.

**Fügeverfahren zur Verbindung von HDB mit elektrischen Kontakten von thermisch untergeordneter Funktion nach dem Stand der Technik** sind das Bonden und das Löten.

**Anordnungen von HDB und einem elektrischem Kontakt von thermisch untergeordneter Punktion nach dem Stand der Technik** weisen eine Fügezone zwischen HDB und elektrischem Kontakt auf, die als Bondschweißnaht oder Lotfuge ausgeführt ist. Die Fügezonen unterscheiden sich je nach Fügeverfahren dadurch, daß die Fügezone zwischen HDB und elektrischem Kontakt im Falle des Lötens durch einen zusätzlichen Fügewerkstoff, dem Lot, gebildet wird, während die Fügezone beim Bonden keinen zusätzlichen Fügewerkstoff benötigt.

Beim Bonden wird der elektrische Kontakt, beispielsweise ein oder mehrere Bonddrähte, unter lokaler Einwirkung von Ultraschall, Druck und/ oder Wärme mit dem HDB über dessen Metallisierung verbunden. Die beim Bondprozeß lokal auftretenden mechanischen Kräfte können dabei den HDB überlasten und beschädigen. Wegen des geringen Durchmessers von Bonddrähten und der hohen im Betrieb des HDL auftretenden Stromstärken muß der HDB mit einer Vielzahl von Bonddrähten verbunden sein, die sich nur sequentiell anbringen lassen. Nachteilig bei der Kontaktierung des HDB mit Bonddrähten ist zudem, daß zum Ausgleich des inhomogenen Stromeintrags auf den HDB letzterer mit einer besonders dicken Metallisierung versehen sein muß. Drahtbondprozesse weisen schließlich einen erhöhten Platzbedarf jenseits des HDB auf. Dies ist sowohl nachteilig für die Flexibilität des Verbindungsprozesses als auch für die Integrationsfähigkeit von HLD in Systemen.

Beim Löten wird eine stoffschlüssige Verbindung zwischen der Metallisierung des HDB und dem metallischen oder metallisierten elektrischen Kontakt unter Zuhilfenahme eines Lotwerkstoffes erzielt. Die Verbindung beruht auf Diffusionsvorgängen zwischen dem Lotwerkstoff und den Werkstoffen der Metallisierung des HDB und des elektrischen. Kontaktes. Die Diffusionsvorgänge beginnen unmittelbar mit dem Inkontaktbringen der Metalle und des Lotes bei Schmelztemperatur des Lotes oder des Metall-Lot-Eutektikums.

Nachteilig am Lötprozeß ist die benötigte Wärmeeinwirkung und deren Folgen: Die beiden Fügepartner, HDB und elektrischer Kontakt, haben in der Regel einen unterschiedlichen thermischen Ausdehnungskoeffizienten. Beim Abkühlen unterhalb der Verfestigungstemperatur der Lotfuge auf Raum- bzw. Betriebstemperatur kommt es dadurch zur Einbringung mechanischer Spannungen in den HDB, die schädlich für seine Lebensdauer sind. Insbesondere bei Lötverbindungen des HDB mit einem großflächigen Kontakt treten hohe mechanische Spannungen auf. Spannungsreduzierende Weichlote neigen wiederum zu Elektromigration, die einer ausreichenden HDB-Lebensdauer ebenfalls abträglich sind.

Die Verwendung von elektromigrationsfesten Hartloten und elektrischen Kontakten von ähnlichen Ausdehnungskoeffizienten wie das HDB-Material schränkt zum einen die Auswahl möglicher elektrischer Kontakte stark ein und benötigt zudem sehr hohe Löttemperaturen die für den HDR schädlich sein könnten.

Die Aufbringung des Lotes vor der Lötung auf einen der Fügepartner ist technisch aufwendig: Sie erfolgt in der Regel über eine Besputterung, Bedampfung oder Galvanisierung des elektrischen Kontakts.

Als ein wesentlicher Nachteil ist hervorzuheben, daß alle Lötprozesse den Einsatz eines Flußmittels oder eines Formiergases als Reduktionsmittel für den Lotwerkstoff benötigen, um eine zuverlässige Lötverbindung zwischen den Fügepartnern herzustellen. Diese Mittel können aber durch ihre chemische Agressivität die empfindlichen Facetten des HDB schädigen. Ein Verzicht auf am Fügeprozeß zusätzlich beteiligte gasförmige oder flüssige Substanzen ist daher äußerst wünschenswert.

Schließlich benötigt der Lötprozeß, ebenso wie der Drahtbondprozeß eine Metallisierung der Fügepartner, insbesondere des HDB. Diese stellt bei des HDB-Herstellung einen zusätzlichen aufwendigen Prozeß dar.

Der wesentliche Vorteil einer Lötverbindung jedoch, nämlich die gute thermische Anbindung eines wärmeerzeugenden Fügepartners an einen wärmeabführenden Fügepartner, ist bei der Verbindung eines HDB mit einem elektrischen Kontakt von thermisch untergeordneter Funktion hinfällig.

Zusammengefaßt stellen sich die Nachteile von Lötverbindungen folgendermaßen dar: Eine Lötverbindung induziert immer einen schädlichen Betrag an mechanischen Spannungen im HDB. Fallen die mechanischen Spannungen gering aus, besteht für die Verbindung die erhöhte Anfälligkeit für Elektromigration. Der Einsatz von Reduktionsmitteln für den Lotwerkstoff ist bei einer lunkerarmen und langzeitstabilen Lötung nicht zu vermeiden und stellt eine Gefahr für die Facetten dar.

Allgemein nachteilig an den Fügeverfahren für einen HDB und einen elektrischen Kontakt von thermisch untergeordneter Funktion nach dem Stand der Technik ist es, daß der FügeprozeB für stoffschlüssige Verbindungen zwischen Kontakt und HDB eine Gefügeveränderung an der Metallisierung des HDB hervorruft, die verfahrensbedingt den HDB schädlichen mechanischen Spannungen aussetzt, und bzw. oder den Einsatz gasförmiger oder flüssiger chemischer Hilfsstoffe' erfordert, von deren schädlichem Einfluß der HDB nur unzureichend abgeschirmt werden kann.

Nachteilig an den Fügezonen stoffschlüssiger HDB-Kontakt-Anordnungen mit einem elektrischen Kontakt von thermisch untergeordneter Funktion nach dem Stand der Technik ist es, daß die Fügezone der Partner, HDB und Kontakt, aufgrund ihrer Beschaffenheit bei der Herstellung der Verbindung den HDB schädlichen mechanischen Spannungen, bzw. seine Facetten schädlichen chemischen Einflüssen, aussetzt.

Aus der US 5 284 790 ist ein Verfahren zur Herstellung eines monolithischen Laserdiodenarrays bekannt, bei dem Laserdioden in Nuten in einem monolithischen Substrats eingesetzt werden, wobei ein elektrischer und mechanischer Kontakt. zu den Laserdioden über metallisierte Seitenwänden hergestellt Wird.

Die EP 0 905 833 A2 beschreibt die elektrische Kontaktherstellung zwischen zwei Substraten mittels eines anisotrop elektrisch leitfähigen Klebers, der elektrisch leitfähige Partikel enthält, die eine elektrische Leitfähigkeitscharakteristik ausschließlich in einer Richtung senkrecht zu den Substraten aufweisen.

Das Dokument US-A- 5 212 707 offenbart ein Fügeverfahren und eine Hochleistungsdiodenlaserdisodenlaserbarren-Kontakt - Anordnung gemäß des Oberbegriffs der Ansprüche 1 und 5.

**Aufgabe der Erfindung** ist es, ein Fügeverfahren für eine stoffschlüssige Verbindung von einem HDB und einem elektrischen Kontakt von thermisch untergeordneter Funktion zu schaffen, das die Nachteile der herkömmlichen stoffschlüssigen Verbindungen und die nachteiligen Einflüsse herkömmlicher stoffschlüssiger Verbindungsprozesse nicht aufweist

Gleichzeitig ist es Aufgabe der Erfindung, eine HDB-Kontakt-Anordnung mit einem elektrischen Kontakt von thermisch untergeordneter Funktion mit einer Fügezone zu schaffen, die die Nachteile herkömmlicher Fügezonen in HDB-Kontakt-Anordnungen mit einem elektrischen Kontakt von thermisch untergeordneter Funktion nicht aufweist.

**Erfindungsgemäß wird die Aufgabe durch ein Fügeverfahren gemäß des Anspruchs 1 gelöst,** das unter der Beteiligung von einem Adhäsionsmittel HDB und elektrischen Kontakt von thermisch untergeordneter Funktion in einem Adhäsionsprozeß miteinander verbindet.

**Erfindungsgemäß wird die Aufgabe durch eine HDB-Kontakt-Anordnung gemäß des Anspruchs 5, mit einem elektrischen Kontakt von thermisch untergeordneter Funktion gelöst,** deren Fügezone einen Fügewerkstoff mit einem Adhäsionsmittel enthält.

Vorteilhaft an der erfindungsgemäßen Lösung einer adhäsiven Verbindung von Kontakt und HDB ist die mechanische Spannungsarmut der Fügezone: Der Beginn des adhäsiven Verbindungsprozesses erfolgt bei Inkontaktbringen der Fügepartner mit dem Adhäsionsmittel des Fügewerkstoffes. Der Fügeprozeß endet mit dem Erreichen jener Eigenschaften der Fügezone, die nötig sind um die Funktion der Verbindung zu erfüllen. Der Fügeprozeß kann bei Raumtemperatur erfolgen und damit für den Laser mechanisch spannungsfrei ablaufen. Er kann bei Betriebstemperatur des Lasers erfolgen und damit ein für den Laser mechanisch spannungsfreien Betrieb ermöglichten.

Der Fügeprozeß kann auch bei erhöhter Temperatur erfolgen, um eine Beschleunigung des Fügeprozesses und und/ oder eine Verbesserung der Eigenschaften der Fügezone zu erreichen. Dabei wird vorausgesetzt, daß der adhäsionsmittelhaltige Fügewerkstoff durch plastischen Eigenschaften bei ausreichender Dicke der Fügezone bei anschließender Abkühlung die sich entwickelnden thermomechanischen Spannungen zwischen den Fügepartnern durch einen Fließprozeß gering hält.

Es kann von Vorteil sein, wenn der Fügewerkstoff neben dem Adhäsionsmittel elektrisch leitfähiges Material, zum Beispiel einen metallischen Füllstoff, enthält, das die elektrische Verbindung zwischen Kontakt und HDB verbessert.

Bei den Eigenschaften eines möglichen Füllstoffes kommt es in erster Linie nicht auf eine gute thermische Leitfähigkeit an, weil der zu fügende elektrische Kontakt nur von thermisch untergeordneter Bedeutung ist.

Im Gegensatz dazu kann es in bestimmten Fällen von Vorteil sein, wenn der Fügewerkstoff außer dem Adhäsionsmittel keine weiteren Bestandteile enthält. So lassen sich sehr schmale Fügezonen erreichen, die auch bei Verwendung eines nichtmetallischen Adhäsionsmittels eine elektrisch gut leitfähige Verbindung zwischen dem elektrischen Kontakt und dem HDB erzielen, zum Beispiel dann, wenn die Dicke der Fügezone im Bereich der Oberflächenrauhigkeit der Fügepartner liegt.

Eine bevorzugte Ausführung der adhäsiven Verbindung kann dabei auf eine lötfähige Metallisierung des HDB wie zum Beispiel Gold, und auch des Kontaktes verzichten, weil ein Adhäsionsmittel diese nicht unbedingt benötigt. Auch auf eine Diffusionssperrschicht, wie bei Lötungen üblich, kann gegebenenfalls je nach Art des Adhäsionsmittels und der Füllstoffe des adhäsiven Fügewerkstoffes, verzichtet werden.

Ein Fügewerkstoff mit Adhäsionsmittel läßt sich relativ unproblematisch mit einer einfachen Vorrichtung direkt auf einen der Fügepartner auftragen, ohne daß technisch aufwendige Maschinen wie für eine Lotbedampfung oder Bondung dafür nötig sind.

Die Einsetzbarkeit von Fügewerkstoffen mit Adhäsionsmitteln zur Verbindung eines HDB und einen elektrischen Kontakt von thermisch untergeordneter Funktion ist insbesondere deswegen möglich, weil wesentliche, die adhäsive Verbindung begünstigende Faktoren, allein aus den Gegebenheiten des HDB und des elektrischen Kontaktes sowie den für den Betrieb eines HDL nötigen Bedingungen resultieren:
Adhäsionsmittelhaltige Fügewerkstoffe besitzen zumeist eine deutlich geringere thermische Leitfähigkeit als Lotwerkstoffe. Doch der Einsatz des adhäsionsmittelhaltigen Fügewerkstoffes zur Verbindung eines HDB und eines elektrischen Kontaktes von thermisch untergeordneter Funktion muß keine nennenswerten Wärmeleistungen überführen und deswegen auch keine gute thermische Leitfähigkeit besitzen.
Adhäsionsmittelhaltige Fügewerkstoffe besitzen meist auch unter dem Zusatz von elektrisch leitfähigen Füllstoffen noch eine recht geringe elektrische Leitfähigkeit. Doch bei der Verwendung der großflächigen und parallelen Fügeebenen zwischen HDB-Anode oder -Kathode und elektrischem Kontakt ist die Fügezone sehr ausgedehnt und läßt sich in ihrer Dicke zudem sehr gering, das heißt unter 100 µm, halten. Damit ist auch der elektrische Widerstand der Fügezone gering. Adhäsionsmittelhaltige Fügewerkstoffe besitzen oft eine recht niedrige Glasübergangstemperatur von etwa 100 °C und sind damit von Anwendungen bei höheren Temperaturen ausgeschlossen. In der adhäsionsmittelhaltigen Fügezone können nun auch trotz ihres geringen elektrischen Widerstands wegen der hohen Betriebsströme des HDL einige hundert Milliwatt bis einige Watt Wärmeleistung produziert werden, die die Gefahr einer Überhitzung der Fügezone birgt. Doch der HDB als stark wärmeproduzierendes und extrem temperaturempfindliches elektrooptisches Bauelement darf ebensowenig hohen Temperaturen ausgesetzt werden. Deswegen wird er im cw-Betrieb von einer Seite über den elektrischen Kontakt mit thermisch relevanter Funktion gut gekühlt. Da das HDB-Substrat im Verhältnis zu seiner Fläche sehr dünn ist, wird auch die dem elektrischen Kontakt mit thermisch relevanter Funktion abgewandte Seite, an der sich auch die adhäsionsmittelhaltige Fügezone zum elektrischen Kontakt von thermisch untergeordneter Funktion befindet, gut gekühlt. Die Betriebstemperatur des HDB liegt meist deutlich unter 100 °C, typischerweise bei etwa 50 bis 70 °C. Die Fügezone produziert nur einen geringen Bruchteil der gesamten Wärme, die im HDB produziert wird. Deswegen wird die adhäsionsmittelhaltige Fügezone im Betrieb höchstens unwesentlich wärmer als die Wärmequelle im HDB.
Adhäsionsmittelhaltige Fügewerkstoffe sind oft hygroskopisch. Der ebenso feuchtigkeitsempfindliche HDB muß vor Betauung, insbesondere bei niedrigen Temperaturen geschützt werden. Dazu wird der HDL oft in ein trockenes oder hermetisch dichtes Gehäuse eingebaut. Diese für den HDB trockene Umgebung schützt auch die adhäsionsmittelhaltige Fügezone.

Nachfolgend wird das erfindungsgemäße Fügeverfahren und die erfindungsgemäße HDB-Kontakt-Anordnung an Hand von vier Ausführungsbeispielen erläutert. Dazu zeigen die Figuren:
Fig. 1 ein erstes Ausführungsbeispiel einer erfindungsgemäßen Anordnung eines HDL, bestehend aus einem einem elektrischen n-Kontakt, einem HDB und einer adhäsionsmittelhaltigen Fügezone, die beide miteinander verbindet.
Fig. 1a eine vorteilhafte Ausführung des elektrischen n-Kontaktes des ersten Ausführungsbeipiels
Fig. 1b eine erste vorteilhafte Ausführung der adhäsionsmittelhaltigen Fügezone des ersten Ausführungsbeipiels
Fig. 1c eine zweite vorteilhafte Ausführung der adhäsionsmittelhaltigen Fügezone des ersten Ausführungsbeipiels
Fig. 2 ein zweites Ausführungsbeispiel einer erfindungsgemäßen Anordnung eines HDL adressierbarer Emitter, bestehend aus einem einem elektrischen p-Kontakt, einem HDB und einer adhäsionsmittelhaltigen Fügezone, die beide miteinander verbindet.
Fig. 2a eine vorteilhafte Ausführung der adhäsionsmittelhaltigen Fügezone des zweiten Ausführungsbeipiels
Fig. 3 ein drittes Ausführungsbeispiel einer erfindungsgemäßen Anordnung eines gepulst zu betreibenden HDL mit zwei HDB, bestehend aus einem elektrischen Kontakt, der als ein erster HDB ausgeführt ist, einem zweiten HDB und einer adhäsionsmittelhaltigen Fügezone, die beide miteinander verbindet.

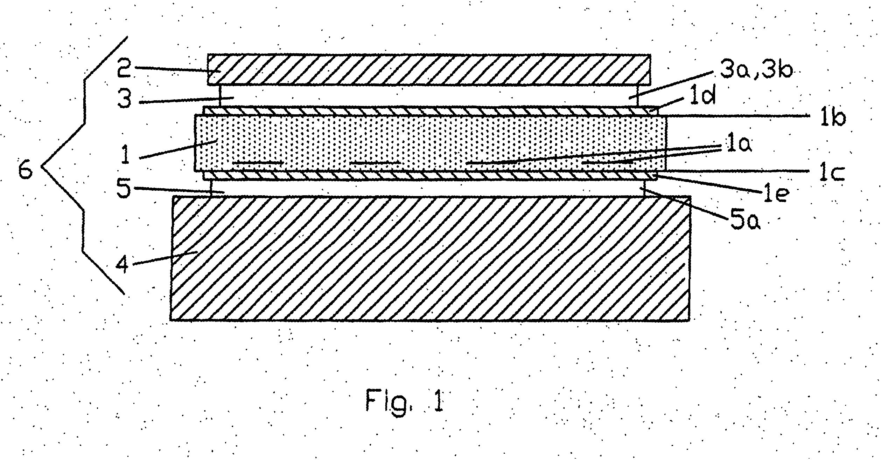

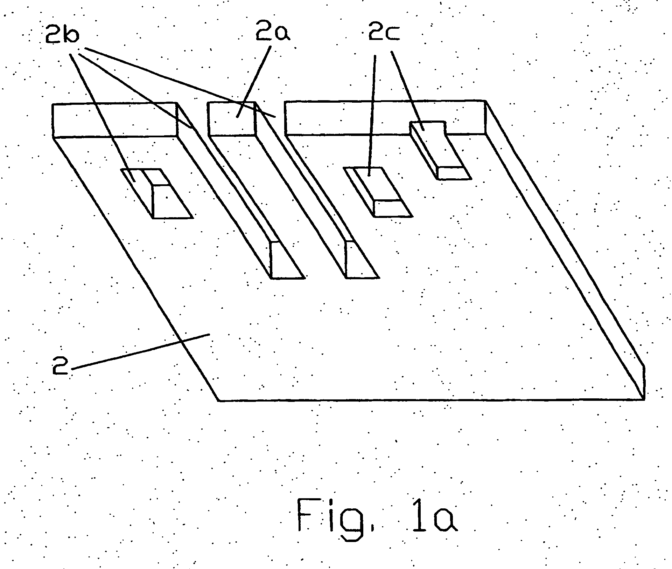

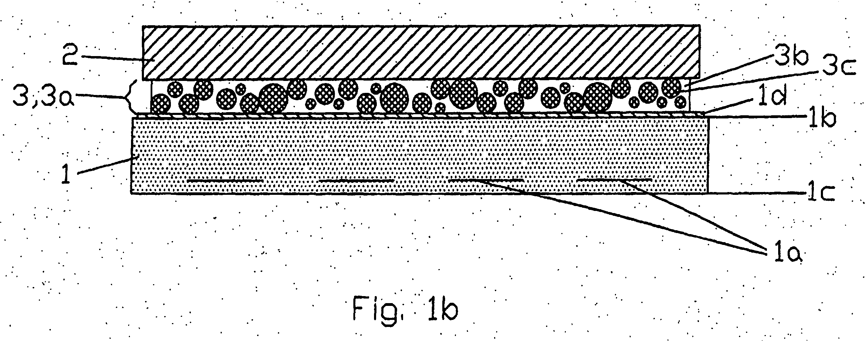

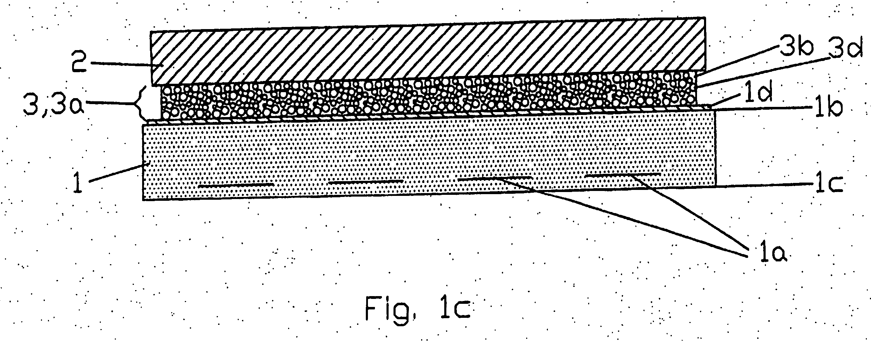

**Das in Figur 1 dargestellte erste Ausführungsbeipiel** zeigt einen HDL (6) mit einem HDB (1), der aus einem etwa 100 µm dünnen n-dotierten GaAs-Substrat besteht, auf das eine ternäre oder quaternäre Halbleiter-Heterostruktur mit der Funktion eines pn-Übergangs zu Laseremittern (1a) ausgebildet mit abschließender p-dotierter GaAs-Schicht epitaktisch aufgebracht wurde. Die substrat(n-)seitige Oberfläche stellt die Kathode (1b) des HDB dar, die epitaxie(p-)seitige Oberfläche die Anode (1c). Die Kathode trägt eine Metallisierung (1d), die Anode eine Metallisierung (1e). Der HDB (1) ist mittels eines Lotes (5a) "p-side-down" über eine Lotfuge (5) auf eine Wärmesenke (4) aufgelötet, die einen elektrischen p-Kontakt mit thermisch relevanter Funktion darstellt. Ein Metallfilm (2) aus Kupfer von etwa 50 µm Dicke stellt den n-seitigen elektrischen Kontakt von thermisch untergeordneter Relevanz des HDB dar.

Auf die n-seitige Metallisierung des HDB wird als adhäsionsmittelhaltiger Fügewerkstoff (3a) ein elektrisch leitfähiger Kleber (3b) aufgebracht.

Beide Fügepartner, HDB (1) und Metallfilm (2), werden vermittels des Fügewerkstoffes (3a) bei Raumtemperatur miteinander in Kontakt gebracht, indem der Metallfilm (2) in den auf den HDB (1) aufgetragenen Fügewerkstoff (3a) gedrückt wird. Die Dicke der Fügezone (3) stellt sich dabei auf etwa 20 µm ein. Der Fügeprozeß wird fortgesetzt, indem die Elemente bei einer erhöhten Temperatur von etwa 100 °C gelagert werden. Dabei erfolgt eine Aushärtung des Klebers (3b), die zur stoffschlüssigen Verbindung der Fügepartner führt. Bei der Abkühlung des HDL (6) nach dem Ende des Fügeprozesses werden aufgrund der im Vergleich zum HDB (1) dünnen Metallfolie und der ausreichend dicken, plastischen Fügezone (3) des Klebspaltes keine schädlichen thermomechanischen Spannungen auf den HDB (1) übertragen.

Eine bevorzugte Variante dieses ersten Ausführungsbeispieles besteht darin, auf die Metallisierungen (1d, 1e) des HDB (1) zu verzichtet.

Bevorzugte Varianten für den n-Kontakt dieses ersten Ausführungsbeispieles sind in

Fig. 1a veranschaulicht und bestehen darin, in den Metallfilm (2) Öffnungen (2b) oder Vertiefungen (2c) in Form von Nuten oder Gruben, einzubringen, die überschüssigen Fügewerkstoff aufnehmen können. So läßt sich trotz Dosierungsungenauigkeiten eine ausreichend dünne Klebefuge erreichen, ohne daß die Gefahr besteht, daß der Fügewerkstoff vor die Facette des HDB quillt. Mehrere Öffnungen (2b) nebeneinander können den n-Kontakt mit Kontaktfahnen (2a) ausstatten, die außerdem die Flexibilität des Metallfilmes erhöhen.

Eine bevorzugte Variante des ersten Ausführungsbeipieles ist in Fig. 1b dargestellt und besteht in der Verwendung eines Fügewerkstoffes (3a) in der Fügezone (3), der neben dem nicht mehr notwendigerweise elektrisch leitfähigen Kleber (3b) zusätzlich einen metallischen Füllstoff von kleinen Silberpartikeln von etwa 10 µm bis maximal 20 µm Größe (3c) enthält. Dieser Zusatz erniedrigt den elektrischen Widerstand der Fügezone. Die Dicke der Fügezone stellt sich durch Gegeneinanderdrücken der beiden Fügeflächen der Kontaktpartner, bedingt durch die größten Silberpartikel im Kleber, auf etwa 20 µm ein.

Eine andere bevorzugte Variante des ersten Ausführungsbeispiels ist in Fig. 1c dargestellt und verwendet bei gleicher Fügezonendicke anstatt einer Silberpartikeln (3c) einer Größe von 10 µm bis 20 µm nur Silberpartikel (3d) von weniger als 5 µm Größe. Damit kann eine punktuelle Überhöhung des Anpreßdruckes von Silberpartikeln auf den HDB vermieden werden, wenn die Dicke der Fügezone (20 µm) deutlich größer ist als die Partikelgröße (5 µm).

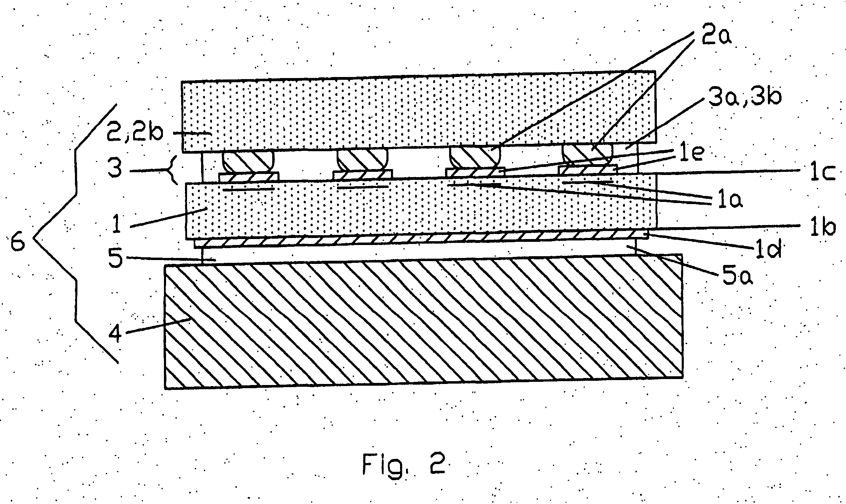

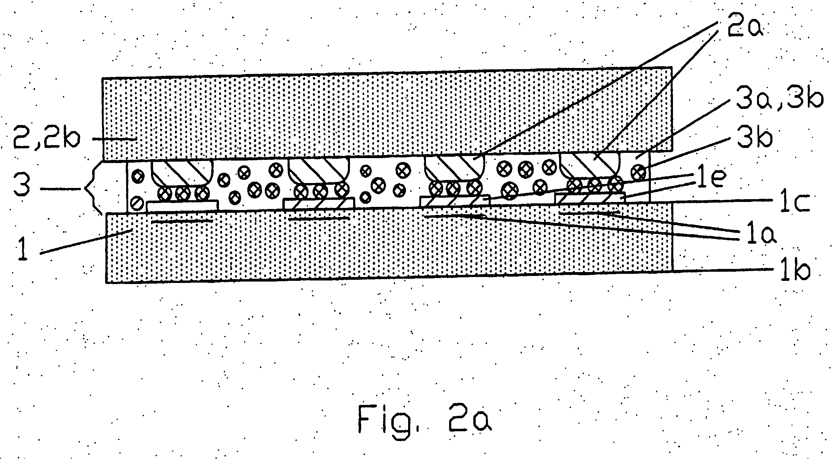

**Das in Figur 2 dargestellte zweite Ausführungsbeipiel** zeigt einen HDL (6) mit einem HDB (1) adressierbarer Emitter (1a), der aus einem etwa 100 µm dünnen n-dotierten GaAs-Substrat besteht, auf das eine ternäre oder quaternäre Halbleiter- Heterostruktur mit der Funktion eines pn-Übergangs zu Laseremittern (1a) ausgebildet mit abschließender p-dotierter GaAs-Schicht epitaktisch aufgebraucht wurde. Die substrat(n-)seitige Oberfläche stellt die Kathode (1b) des HDB dar, die epitaxie(p-)seitige Oberfläche die Anode (1c). Die Kathode trägt eine Metallisierung (1d), die Anode Metallisierungen (1e) für jeden Emitter. Der HDB (1) ist subtratseitig mittels eines Lotes (5a) "p-side-up" über eine Lotfuge (5) auf eine Wärmesenke (4) aufgelötet, die einen elektrischen n-Kontakt mit thermisch relevanter Funktion darstellt. Ein Aluminiumoxid-Keramik-Substrat (2b) mit Leiterzügen aus Dickschicht-Gold (2a) von etwa 20 µm Höhe für jeden Emitter stellt den p-seitigen elektrischen Kontakt (2) von thermisch untergeordneter Relevanz des HDB (1) dar.

Auf die p-seitige Metallisierung des HDB wird als adhäsionsmittelhaltiger Fügewerkstoff (3a) ein elektrisch isolierender Kleber (3b) aufgebracht.

Beide Fügepartner, HDB (1) und metallisierte Keramik (2), werden durch Verdrängung des Fügewerkstoffes (3a) bei Raumtemperatur miteinander in Kontakt gebracht, indem die Leiterzüge (2a) die Metallisierungen (1e) des HDB (1) bedingt durch ihre jeweiligen Oberflächenrauhigkeiten berühren. Die Dicke der Fügezone (3) liegt zwischen den beiden Metallisierungen in der Größenordnung der Oberflächenrauahigkeit. Zwischen den Leiterzügen (zwischen den Emittern) liegt die Dicke der Fügezone etwa bei der Dicke der Leiterzüge (20 µm). Die Aushärtung des Klebers (3b) erfolgt bei Raumtemperatur und führt zur stoffschlüssigen Verbindung der Fügepartner. Auch bei einer Aushärtung bei erhöhter Temperatur würden bei der Abkühlung des HDL (6) nach dem Ende des Fügeprozesses kaum schädliche Spannungen auf den HDB übertragen, weil das Aluminiumoxid des Substrats einen dem GaAs ähnlichen Wert des Ausdehnungskoeffizienten aufweist.

Eine bevorzugte Variante dieses zweiten Ausführungsbeispieles kann zu einer Verbesserung des elektrischen Übergangs in der Fügezone zwischen Leiterzug (2a) und Anoden-Metallisierung (1e) führen. Sie ist in Figur 2a veranschaulicht und besteht besteht darin, dem elektrisch isolierenden Kleber (3b) des Fügewerkstoffes (3a) einen metallischen Füllstoff von kleinen Silberpartikeln (3c) von 10 µm Größe in feiner Verteilung hinzuzufügen. Dieser Zusatz erniedrigt den elektrischen Widerstand der Fügezone (3) zwischen Leiterzügen (2a) und Anodenmetallisierung (1e), wenn die Dicke der Fügezone auf die Größe der Silberpartikel eingestellt wird, und die Silberpartikel so in Kontakt mit beiden Fügepartnern gebracht werden. Zwischen den Leiterbahnen liegen die Silberpartikel soweit auseinander, daß zwischen Ihnen kein nennenswerter elektrischer Strom fließen kann. Die Einzelansteuerbarkeit der Emitter ist damit gewährleistet. Dieses Verfahren des adhäsiven Fügens wird anisotrop elektrisch leitfähiges Kleben genannt.

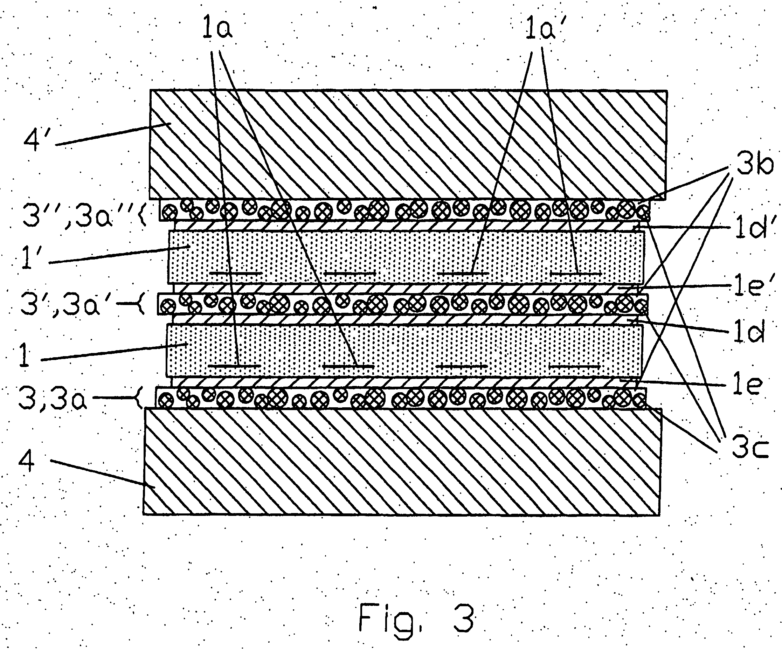

Das in Figur 3 dargestellte dritte Ausführungsbeipiel zeigt einen HDL (6), der für den gepulsten Betrieb mit 1 ms Pulsen bei 1 Hz Wiederholfrequenz vorgesehen ist, mit zwei HDB (1, 1'), die aus etwa 100 µm dünnen n-dotierten GaAs-Substraten bestehen, auf die ternäre oder quaternäre Halbleiter-Heterostrukturen mit der Funktion von pn-Übergangen zu Laseremittern (1a, 1a') ausgebildet mit abschließender p-dotierter GaAs-Schicht epitaktisch aufgebracht wurde. Die substrat(n-)seitige Oberfläche stellt die Kathode (1b, 1b') des HDB dar, die epitaxie(p-)seitige Oberfläche die Anode (1c, 1c'). Die Kathode trägt eine Metallisierung (1d, 1d'), die Anode eine Metallisierung (1e, 1e')

Ein Kupferträger (4) dient als elektrischer p-Kontakt von thermisch untergeordneter Funktion für den ersten HDB (1) und wird mit einer Schicht Fügewerkstoff (3a) versehen, der neben einem Klebstoff (3b) elektrisch leitfähige Partikel (3c) aus Gold von weniger als 2 µm Größe enthält. Die Kathodenmetallisierungen (1d, 1d') des ersten HDB (1) und des zweite HDB (1') werden mit dem gleichen Fügewerkstoffportionen (3a', 3a") versehen. Der erste HDB (1) wird p-seitig in die Schicht Fügewerkstoff (3a) des Kupferträgers (4) gedrückt, der zweite HDB (1') stellt den n-Kontakt von thermisch untergeordneter Funktion für den ersten HDB (1) dar und wird p-seitig in die Schicht Fügewerkstoff (3a') an der Kathodenmetallisierung (1d) des ersten HDB (1) gedrückt. Gleichzeitig stellt der erste HDB (1) den p-Kontakt von thermisch untergeordneter Funktion für den zweiten HDB (1') dar. Ein zweiter Kupferträger (4') stellt den n-Kontakt von thermisch untergeordneter Funktion für den zweiten HDB (1') dar und wird in die Schicht Fügewerkstoff (3a") an der Kathodenmetallisierung (1d') des zweiten HDB (1') gedrückt. Die Aushärtung des Klebers (3b) erfolgt bei Raumtemperatur und führt zur stoffschlüssigen Verbindung aller vier Fügepartner In allen Fällen stellt sich eine Dicke der drei Fügezonen (3, 3', 3") von 2 bis 4 µm ein.

Eine bevorzugte Weiterbildung des dritten Ausführungsbeipieles besteht in der Verwendung weiterer, das heißt mehr als zwei, HDB im HDB-Stapel.

## Patentansprüche

1. Verfahren zum Fügen eines elektrischen Kontaktes (2) an einen Hochleistungsdiodenlaserbarren HDB (1), wobei der Kontakt (2) und der HDB (1) vermittels eines Fügewerkstoffes (3a) gefügt werden, der ein Adhäsionsmittel (3b) enthält und eine elektrisch leitfähige Verbindung realisiert, **dadurch gekennzeichnet, daß** der elektrische Kontakt derart gestaltet ist, daß über den elektrischen Kontakt (2) höchstens ein Drittel der im HDB. (1) im cw-Betrieb erzeugten thermischen Leistung abgeführt wird.

2. Verfahren nach Anspruch 1 **dadurch gekennzeichnet, daß** das Adhäsionsmittel (3b) des Fügewerkstoffes (3a) nichtmetalfisch ist.

3. Verfahren nach einem der vorhergehenden Ansprüche **dadurch gekennzeichnet, daß** der Fügewerkstoff (3a) neben dem Adhäsionsmittel (3b) elektrisch leitfähiges Material (3c, 3d) enthält.

4. Verfahren nach einem der vorhergehenden Ansprüche **dadurch gekennzeichnet, daß** der Fügewerkstoff (3a) seine funktionellen Eigenschaften nach einem Aushärte prozeß für das Adhäsionsmittel (3b) erhält.

5. Hochleistungsdiodenlaserbarren-Kontakt-Anordnung, bestehend aus einem Hochleistungsdiodenlaserbarren HDB(1), einem elektrischen Kontakt (2) und einer Fügezone (3) zwischen HDB (1) und Kontakt (2), wobei die Fügezone (3) einen adhäsionsmittelhaltigen Fügewerkstoff (3a) enthält, der eine elektrisch leitfähige Verbindung realisiert **dadurch gekennzeichnet, daß** der elektrische Kontakt derart gestaltet ist, daß über den elektrischen Kontakt (2) höchstens ein Drittel der im HDB (1) im cw-Betrieb erzeugten thermischen Leistung abgeführt wird.

6. Hochleistungsdiodenlaserbarren-Kontakt-Anordnung nach Anspruch 5 **dadurch gekennzeichnet, daß** der HDB (1) mit wenigstens einer elektrisch leitfähigen Schicht (1d) versehen ist.

7. Hochleistungsdiodenlaserbarren-Kontakt-Anordnung nach einem der Ansprüche 5 und 6 **dadurch gekennzeichnet, daß** der elektrische Kontakt (2) ein substratseitiger elektrischer Kontakt für den HDB (1) ist.

8. Hochleistungsdiodenlaserbarren-Kontakt-Anordnung nach Anspruch 7 **dadurch gekennzeichnet, daß** der elektrische Kontakt (2) ein Metallfilm von einer Dicke von weniger als 100 µm ist.

9. Hochleistungsdiodenlaserbarren-Kontakt-Anordnung nach Anspruch 8 **dadurch gekennzeichnet, daß** der Metallfilm (2) Kontaktfahnen (2a), Öffnungen (2b), Nuten oder Gruben (2c) aufweist.

10. Hochleistungsdiodenlaserbarren-Kontakt-Anordnung nach einem der Ansprüche 5 bis 7 **dadurch gekennzeichnet, daß** der elektrische Kontakt (2) ein zweiter HDB ist.

11. Hochleistungsdiodenlaserbarren-Kontakt-Anordnung nach einem der Ansprüche 5 und 6 **dadurch gekennzeichnet, daß** der elektrische Kontakt (2) ein epitaxieseitiger elektrischer Kontakt mit einem elektrisch separaten Leiterzug für jeden Emitter (1a) im HDB (1) ist.

12. Hochleistungsdiodenlaserbarren-Kontakt-Anordnung nach Anspruch 11 **dadurch gekennzeichnet, daß** die Fügezone (3) anisotrop elektrisch leitfähig ist.

13. Hochleistungsdiodenlaserbarren-Kontakt-Anordnung nach einem der Ansprüche 5 bis 12 **dadurch gekennzeichnet, daß** die Fügezone (3) eine Schichtdicke von weniger als 100 µm aufweist.

14. Hochleistungsdiodenlaser (6) bestehend aus einer Hochleistungsdiodenlaserbarren-Kontakt-Anordnung nach Anspruch 5, **dadurch gekennzeichnet, dass** ein weiterer elektrischer Kontakt (4), über den mehr als ein Drittel der im HDB (1) im Dauerstrich Betrieb erzeugten thermischen Leistung abgeführt wird, auf dem HDB (1) mittels eines Lotes (5a) über eine Lotfuge (5) aufgelötet ist.

## Claims

1. Method of joining an electrical contact (2) to a high power diode laser bar HDB (1), wherein the contact (2) and the HDB (1) are joined by means of a joining material (3a) which contains an adhesive (3b) and which realises an electrically conductive connection, **characterised in that** the electrical contact is designed such that not more than one third of the thermal energy generated in the HDB (1) during cw operation is dissipated via the electrical contact (2).

2. Method according to claim 1, **characterised in that** the adhesive (3b) of the joining material (3a) is non-metallic.

3. Method according to any one of the preceding claims, **characterised in that** the joining material (3a) contains electrically conductive material (3c, 3d) in addition to the adhesive (3b).

4. Method according to any one of the preceding claims, **characterised in that** the joining material (3a) obtains its functional properties after a curing process for the adhesive (3b).

5. High power diode laser bar/contact assembly consisting of a high power diode laser bar HDB (1), an electrical contact (2) and a joining zone (3) between the HDB (1) and the contact (2), wherein the joining zone (3) includes an adhesive-containing joining material (3a) which realises an electrically conductive connection, **characterised in that** the electrical contact is designed such that not more than one third of the thermal energy generated in the HDB (1) during cw operation is dissipated via the electrical contact (2).

6. High power diode laser bar/contact assembly according to claim 5, **characterised in that** the HDB (1) is provided with at least one electrically conductive layer (1d).

7. High power diode laser bar/contact assembly according to any one of claims 5 and 6. **characterised in that** the electrical contact (2) is a substrate-side electrical contact for the HDB (1).

8. High power diode laser bar/contact assembly according to claim 7, **characterised in that** the electrical contact (2) is a metal film having a thickness of less than 100 µm.

9. High power diode laser bar/contact assembly according to claim 8, **characterised in that** the metal film (2) comprises contact lugs (2a), openings (2b), grooves or pits (2c).

10. High power diode laser bar/contact assembly according to any one of claims 5 to 7, **characterised in that** the electrical contact (2) is a second HDB.

11. High power diode laser bar/contact assembly according to any one of claims 5 and 6. **characterised in that** the electrical contact (2) is an epitaxial-side electrical contact comprising an electrically separate conductor line for each emitter (1a) in the HDB (1).

12. High power diode laser bar/contact assembly according to claim 11, **characterised in that** the joining zone (3) is anisotropically electrically conductive.

13. High power diode laser bar/contact assembly according to any one of claims 5 to 12, **characterised in that** the joining zone (3) has a layer thickness of less than 100 µm.

14. High power diode laser (6) consisting of a high power diode laser bar/contact assembly according to claim 5, **characterised in that** a further electrical contact (4), by which more than one third of the thermal energy generated in the HDB (1) during continuous-wave operation is dissipated, is soldered onto the HDB (1) via a soldered joint (5) by means of a solder (5a).

## Revendications

1. Procédé de liaison d'un contact électrique (2) à une barrette de laser à diode haute puissance HDB (1), procédé dans lequel le contact (2) et la HDB (1) viennent être liés par moyen d'une matière de liaison (3a) contenant un adhésif (3b) et réalisant une connexion électriquement conductrice, ledit procédé étant **caractérisé en ce que** le contact électrique est pourvu de manière à ne pas faire dissiper par le contact électrique (2) plus d'un tiers de l'énergie thermique engendrée dans la HDB (1) en fonctionnement cw.

2. Procédé selon la revendication 1, **caractérisé en ce que** ledit adhésif (3b) de la matière de liaison (3a) est non-métallique.

3. Procédé selon l'une quelconque des revendications précédentes, **caractérisé en ce que** la matière de liaison (3a) contient de la matière électriquement conductrice (3c, 3d) en plus dudit adhésif (3b).

4. Procédé selon l'une quelconque des revendications précédentes, **caractérisé en ce que** la matière de liaison (3a) obtient ses propriétés fonctionnelles après un procédé de durcissage pour l'adhésif (3b).

5. Ensemble barrette de laser à diode haute puissance/contact composé d'une barrette de laser à diode haute puissance HDB (1), d'un contact électrique (2) et d'une zone de liaison (3) entre la HDB (1) et le contact (2), ensemble dans lequel la zone de liaison (3) comporte une matière de liaison (3a) qui contient un adhésif et qui réalise une connexion électriquement conductrice, ledit ensemble étant **caractérisé en ce que** le contact électrique est réalisé de manière à ne faire dissiper par le contact électrique (2) plus d'un tiers de l'énergie thermique engendrée dans la HDB (1) en fonctionnement cw.

6. Ensemble barrette de laser à diode haute puissance/contact selon la revendication 5, **caractérisé en ce que** la HDB (1) est pourvue d'au moins une couche électriquement conductrice (1d).

7. Ensemble barrette de laser à diode haute puissance/contact selon l'une quelconque des revendications 5 et 6, **caractérisé en ce que** le contact électrique (2) est un contact électrique du côté du substrat pour la HDB (1).

8. Ensemble barrette de laser à diode haute puissance/contact selon, la revendication 7, **caractérisé en ce que** le contact électrique (2) est un film métallique d'une épaisseur de moins de 100 µm.

9. Ensemble barrette de laser à diode haute puissance/contact selon la revendication 8, **caractérisé en ce que** le film métallique (2) comporte des cosses de contact (2a), des ouvertures (2b), des rainures ou des creux (2c).

10. Ensemble barrette de laser à diode haute puissance/contact selon l'une quelconque des revendications 5 à 7, **caractérisé en ce que** le contact électrique (2) est une deuxième HDB.

11. Ensemble barrette de laser à diode haute puissance/contact selon l'une quelconque des revendications 5 et 6, **caractérisé en ce que** le contact électrique (2) est un contact électrique du côté épitaxique, ledit contact comportant une ligne conductrice électriquement séparée pour chaque émetteur (1a) dans la HDB (1).

12. Ensemble barrette de laser à diode haute puissance/contact selon la revendication 11, **caractérisé en ce que** la zone de liaison (3) est anisotropiquement électriquement conductrice.

13. Ensemble barrette de laser à diode haute puissance/contact selon l'une quelconque des revendications 5 à 12, **caractérisé en ce que** la zone de liaison (3) présente une épaisseur de couche de moins de 100 µm.

14. Laser à diode haute puissance (6) composée d'un ensemble barrette de laser à diode haute puissance/contact selon la revendication 5, **caractérisé en ce qu'**un contact électrique (4) additionnel, par lequel plus d'un tiers de l'énergie thermique engendrée dans la HDB (1) en fonctionnement en onde entretenue est dissipé, est soudé à la HDB (1) par moyen d'un joint de soudage (5) avec un agent à souder (5a).
